# FASCICULE DE BREVET EUROPEEN

(11) **EP 1 633 830 B1**
(45) Date de publication et mention de la délivrance du brevet: **01.08.2007**
(21) Numéro de dépôt: 04767290.2
(22) Date de dépôt: 09.06.2004
(51) Int. Cl.: C09J 183/04, C08L 83/04, H01L 23/29

(54) **COMPOSITION SILICONE RETICULABLE EN GEL ADHESIF**
ZU EINEM ADHÄSIV WIRKENDEN GEL VERNETZBARE SILICONZUSAMMENSETZUNG
SILICON COMPOSITION WHICH CAN BE CROSSLINKED INTO AN ADHESIVE GEL

(30) Priorité: 16.06.2003 FR 0307210
(43) Date de publication de la demande: 15.03.2006
(73) Titulaire: Bluestar Silicones France, 69486 Lyon (FR)
(72) Inventeur: JUNG, Bernd, 23942 Dassow (DE); DIENEMANN, Joerg, 23701 Eutin (DE); GEORGE, Catherine, F-69290 Saint Genis les Ollières (FR)
(74) Mandataire: Valentino, Cédric
(86) Numéro de dépôt international: PCT/FR2004/001424
(87) Numéro de publication internationale: WO 2005/003250

(56) Documents cités:
- EP-A- 0 737 721
- EP-B- 0 069 451
- EP-B- 0 273 704
- EP-B- 0 727 462
- FR-A- 2 770 220

## Description

Le domaine de la présente invention est celui des compositions à base de polyorganosiloxanes (POS) aptes à réticuler par des réactions d'addition ou d'hydrosilylation, faisant intervenir des substituants hydrogènes et des radicaux éthylèniquement insaturés, c'est-à-dire des alcényles en particulier du type vinyle. L'hydrosilylation est généralement catalysée par des composés métalliques, par exemple de nature platinique.
La présente invention concerne plus précisément des compositions silicones réticulables en gel adhésif par hydrosilylation, à température ambiante ou par élévation de température. L'invention vise enfin les systèmes précurseurs stockables de tels gels silicones.
Au sens de la présente invention, le terme gel silicone désigne un produit silicone réticulé caractérisé par un taux de pénétration compris par exemple entre 20 à 500 dixièmes de mm (mesure par pénétrométrie ASTM D 2137, poids de la tige et du cône : 62,5 g).

Les gels silicones sont traditionnellement obtenus par réticulation d'une composition comprenant un polyorganosiloxane porteur d'au moins deux fonctions vinyles par molécule, un polyorganohydrogénosiloxane porteur d'au moins deux fonctions SiH par molécule, un polyorganosiloxane non fonctionnalisé et un catalyseur d'hydrosylilation à base de platine. Ces gels silicones mi-solides mi-liquides sont traditionnellement utilisés pour la protection de matériels électroniques sensibles aux vibrations, aux chocs, à la température et de manière plus générale aux agressions physiques et chimiques de l'atmosphère ambiante. Pour leur mise en oeuvre dans cette application, les gels silicones encapsulent les composants électroniques ("Potting"). Les gels silicones sont aussi utilisés comme matériau médical de base, notamment pour l'élaboration de prothèse, implants ou de pansements. Ils sont aussi utilisés comme adhésif, pour autant que leurs propriétés adhérentes soient significatives et comme matériau amortisseur de choc.

Pour toutes ces applications, les propriétés physiques de ces gels sont adaptées suivant l'utilisation en faisant varier les taux de motifs siloxyles porteurs de fonctions Si-vinyle et SiH.
Cependant, un des problèmes majeurs de ce type de gels silicones est le maintient dans le temps des propriétés physiques, telles que la viscoélasticité, du notamment à la faible intégration dans la matrice réticulée du polyorganosiloxanne non fonctionnalisé, qui de ce fait est facilement extractible par lixiviation entraînant une détérioration des performances du gel comme par exemple les propriétés d'adhésion. C'est pour cette raison que traditionnellement ces gels sont obtenus à partir de composition comprenant un fort pourcentage en poids de polyorganosiloxane non fonctionnalisé, de l'ordre de 50% en poids par rapport au poids total des constituants afin de pouvoir optimiser les propriétés viscoélastiques notamment pour des applications telles que la fabrication de prothèses. De plus, des propriétés adhésives sont souvent recherchées pour des utilisations spécifiques comme par exemple dans le domaine médical ou paramédical avec des applications de type pansements.

On connaît de la demande de brevet européen n° 532 362 des compositions de gel silicone comprenant :
A - un polyorganosiloxane comprenant de 90 à 97 % molaire de motifs D = R(CH3)SiO_{2/2}, 0,1 à 2,5 % molaire de motifs T = R SiO_{3/2}, et 0,1 à 4 % molaire de motifs terminaux M = (CH₃R)SiO_{1/2} avec R = méthyle, phényle ou CF₃CH₂CH₂-, et avec la condition selon laquelle ces deux derniers groupements R représentent 0,5 à 10 % molaire du total des groupements R ;
B - un polyhydrogénoorganosiloxane comprenant au moins un SiH par molécule et déterminant un ratio SiH/SiVi compris entre 0,5 et 1,5, et
C - un catalyseur à base de platine.
La quête d'une autoadhérence pour les gels silicones n'a pas été le moteur de l'invention décrite dans cette demande. Le POS B hydrogéné peut être constitué par un POS du type poly(diméthylsiloxy)α,ω(diméthylhydrogénosiloxy) et éventuellement par un POS du type poly(diméthylsiloxy)(méthylhydrogénosiloxy)α,ω(diméthylhydrogénosiloxy).
Dans cette demande, seuls sont exemplifiés les mélanges, d'une part, de POS α,ω-vinylé et phényle substitués, et d'autre part de POS hydrogénés dans les chaînes et aux extrémités de celles-ci. La viscosité des POS A mis en oeuvre est de l'ordre de 1000 mPa.s, tandis que celle des POS B utilisées pour la préparation des gels, est de l'ordre de 100 mPa.s. La présence de motifs T (SiO_{4/2}, résine) présentés comme promoteurs de stabilité physique des gels à basse température, est une des caractéristiques essentielles de cette proposition technique antérieure. Enfin, il est à souligner qu'il n'est nullement fait allusion au maintient des propriétés physiques dans le temps du gel ou de quelconques propriétés adhésives des gels considérés.

Dans cet état de connaissance, l'un des objectifs essentiel de la présente invention est de fournir des compositions silicones réticulables en gel par hydrosilylation, lesdites compositions se devant de conduire à des gels silicones doués pour le moins des qualités attendues dans les produits de l'art antérieur à savoir : amortissement, vitesse rapide de réticulation et faisabilité industrielle. Ces qualités recherchées dans le cadre de l'invention se doivent en outre d'être meilleures que celles obtenues jusqu'alors. Enfin et surtout, on vise à atteindre des gels silicones présentant des propriétés d'adhérence (d'auto-adhérence) améliorées, lesquelles sont particulièrement souhaitables notamment dans les applications des gels pour les applications médicales et paramédicales, telles que des pansements, pour ne citer qu'elles.

La Demanderesse a mis en oeuvre d'importants moyens de recherche et de nombreuses expérimentations pour atteindre cet objectif parmi d'autres. Et au terme de cela, elle a eu le mérite de trouver, de manière tout à fait surprenante et inattendue, qu'il convient d'introduire dans une composition standard, apte à réticuler pour former un gel silicone, un polyorganosiloxane monofonctionnel porteur d'un seul groupement Si-alcényle par molécule.
Un autre objectif de l'invention est de fournir des gels ayant des propriétés physiques stables dans le temps; c'est-à-dire un gel ne présentant pas une dégradation de ses propriétés physique par lixiviation du polyorganosiloxanne non fonctionnalisé.
Un autre objectif incident de l'invention est de fournir une composition silicone précurseur de gel adhésif, qui soit simple à préparer, économique, stable au stockage, et qui soit aisé à utiliser pour l'utilisateur final, qui applique la composition juste avant qu'elle se transforme en gel in situ.
Un autre objectif incident de l'invention est de fournir un système précurseur de gel silicone adhésif, à base de la composition du type de celle décrite ci-dessus; ledit système se devant d'être une forme stable au stockage et facile à manipuler et à utiliser pour la préparation du gel.
Un autre objectif incident de l'invention est de fournir des applications de la composition ci-dessus et du gel dont elle peut être à l'origine,
- à titre de moyens d'encapsulation et de protection d'unités électroniques ("Potting" i.e. immersion ou bien encore revêtement ou gainage).
- à titre de matériaux médicaux utiles, par exemple, pour la fabrication d'implants, de prothèses, de ciment d'assemblage..... ou bien encore pour la fabrication d'articles orthopédiques ou paramédicaux (pansements),
- à titre de mortier et/ou de mastic d'étanchéification,
- et enfin à titre d'adhésif.

Tous ces objectifs, parmi d'autres, sont atteints par la présente invention qui concerne une composition silicone réticulable en gel adhésif par hydrosilylation, caractérisée en ce qu'elle est constituée essentiellement de:
(A) - au moins un polyorganosiloxane POS (I) comportant :
   a) des motifs siloxyles terminaux de type M = (R)₂(H)SiO_{1/2}
      dans lesquels les radicaux R, identiques ou différents, correspondent à un groupement alkyle linéaire ou ramifié en C1-C6, éventuellement substitué et/ou aryle substitué ou non, et
   b) des motifs siloxyles, identiques ou différents, de type D = (R¹)ₚ(H)_{q}SiO_{2/2}
   dans lesquels les radicaux R¹ répondent à la même définition que R et p= 1 ou 2, q= 0 ou 1 et p+q=2;
   avec la condition selon laquelle le polyorganosiloxane POS (I) comprend au moins deux radicaux SiH par molécule ;
(B) - au moins un polyorganosiloxane POS (II) comportant :
   a) des motifs siloxyles terminaux de type M = (X)ₛ(R²)ₜSiO_{1/2}
      dans lesquels les radicaux R² répondent à la même définition que R, les radicaux X correspondent à des groupements alcényles ayant de 2 à 6 atomes de carbone, de préférence des groupements vinyles, s = 0 ou 1, t= 2 ou 3 et s + t = 3 ; et
   b) des motifs siloxyles, identiques ou différents, de type D = (X)ᵤ(R³)ᵥSiO_{2/2} dans lesquels les radicaux R³ répondent à la même définition que R, les radicaux X correspondent à des groupements alcényles ayant de 2 à 6 atomes de carbone, de préférence des groupements vinyles, u= 0 ou 1, v =1 ou 2 et u+ v = 2,
      avec la condition selon laquelle le polyorganosiloxane POS (II) comprend au moins deux radicaux X par molécule ;
(C) - au moins un polyorganosiloxane monofonctionnel POS (III) essentiellement linéaire, ayant moins de 2 % molaire de motif T= RSiO_{3/2} , de préférence moins de 1,5 % et encore plus préférentiellement moins de 1% molaire de motif T= RSiO_{3/2} et comportant par molécule un groupement alcényle (X) ayant de 2 à 6 atomes de carbone directement lié à un atome de silicium, de préférence un groupement vinyle directement lié à un atome de silicium, ledit POS (III) comprenant :
   a) des motifs siloxyles terminaux, identiques ou différents, de type

      M = (X)_{w}(R⁴)ₓSiO_{1/2}

      dans lequel les radicaux R⁴ répondent à la même définition que R, w= 0 ou 1,x=2 ou 3 et w+x=3; et
   b) au moins un motif siloxyle D = (X)_{y}(R⁵)_{z}SiO_{2/2}
   dans lequel les radicaux R⁵ répondent à la même définition que R, y= 0 ou 1, z=1 ou 2 et y+ z= 2,
(D) - une quantité efficace d'au moins un catalyseur de réaction d'hydrosilylation ; et
(E) - éventuellement au moins un polyorganosiloxane non fonctionnalisé POS (IV) comportant :
   a) des motifs siloxyles terminaux de type M = (R⁶)₃SiO_{1/2}
      dans lesquels les radicaux R⁶ répondent à la même définition que R, et
   b) des motifs siloxyles, identiques ou différents, de type D = (R⁷)₂SiO_{2/2}
      dans lesquels les radicaux R⁷ répondent à la même définition que R ;
avec la condition selon laquelle la quantité des constituants (A),(B), (C) et (E) est choisie de manière à ce que le rapport molaire r des atomes d'hydrogène liés au silicium aux radicaux alcényles (X) liés au silicium soit compris entre 0,2 :1 et 5 :1.

La mise en oeuvre de ces POS spécifiquement sélectionnés permet d'obtenir des gels silicones aux propriétés améliorées, dont certaines vont être énoncées ci-après.
Tout d'abord la vitesse de réticulation de ces gels est élevée, ce qui répond aux exigences de faisabilité et de rentabilité industrielle, notamment de l'application "Potting" de composants électroniques sensibles.
De plus, les propriétés viscoélastiques des gels préparés à partir des compositions selon l'invention correspondent bien à l'état mi-solide/mi-liquide recherché. Cet état est propre à procurer des qualités d'amortissement idoines, qui permettent une parfaite absorption des chocs et des vibrations.
Les gels obtenus ont, en outre, l'avantage d'être stables dans le temps et à basse température (jusqu'à -120°C), c'est-à-dire qu'ils maintiennent leurs propriétés physiques sans présenter une dégradation des propriétés physiques par lixiviation du polyorganosiloxanne non fonctionnalisé.
Il est à souligner que ces qualités sont acquises aux compositions et aux gels selon l'invention, nonobstant la non-présence obligatoire de POS comprenant des motifs T, ce qui va à l'encontre de l'enseignement de l'art antérieur.
Enfin et surtout, l'un des grands intérêts des compositions de l'invention est qu'elles conduisent à des gels silicones adhérents ou auto-adhérents nécessaire à des applications paramédicales telles que par exemple les pansements.
Il est important de noter que ce gain d'adhésion ne se fait pas au détriment des autres propriétés des compositions et des gels de l'invention.

De préférence, la quantité des constituants (A), (B), (C) et (E) est choisie de manière à ce que le rapport molaire r des atomes d'hydrogène liés au silicium aux radicaux alcényles (X) liés au silicium soit compris entre 0,5 :1 et 1,5 :1, et encore plus préférentiellement égale à 1 :1.
De préférence, le catalyseur de réaction d'hydrosilylation est à base de platine.
En pratique, les POS (I) plus volontiers mis en oeuvre sont les polyorganosiloxanes de type poly(diméthylsiloxy)(siloxyméthylhydrogéno)-α,ω-(diméthylhydrogénosiloxy) et les polydiméthylsiloxanes-α,ω-(diméthylhydrogénosiloxy). Ces POS (I) sont des produits commerciaux comme par exemple les produits de la gamme des RHODORSIL_{®} 626V ; RHODORSIL_{®} 620V et RHODORSIL_{®} 628V de la société RHODIA, et sont largement divulgués tant en ce qui concerne leurs structures que leurs synthèses dans la littérature technique.
D'une manière préférée, le POS (I) est sensiblement linéaire, c'est-à-dire qu'il comporte moins de 2% de motif RSi0_{3/2}, et possède une viscosité dynamique inférieure ou égale à 10000 m.Pa.s, de préférence à 6000 mPa.s et encore plus préférentiellement comprise entre 5 et 5000 mPa.s.
Selon une autre variante, le % en poids de groupes réactifs hydrogènes, liés directement à un atome de silicium, est compris entre 1 et 35%.

S'agissant du POS (II), les plus volontiers mis en oeuvre sont des polydiméthylsiloxanes α,ω (diméthyvinylsiloxy) ou des polyorganosiloxanes de type poly(diméthylsiloxy) (méthylvinylsiloxy) α,ω (diméthylvinylsiloxy).
Ces POS (II) sont des produits commerciaux comme par exemple les produits de la gamme des RHODORSIL_{®} 621V de la société RHODIA, et sont largement divulgués tant en ce qui concerne leurs structures que leurs synthèses dans la littérature technique.
D'une manière préférée, le POS (II) est sensiblement linéaire, c'est-à-dire qu'il comporte moins de 1% de motif RSi0_{3/2} , et possède une viscosité dynamique inférieure ou égale à 200 000 m.Pa.s, de préférence à 170 000 mPa.s et encore plus préférentiellement comprise entre 20 et 165 000 mPa.s.
Selon une autre variante, le % en poids de groupes réactifs alcényles liés directement à un atome de silicium, est compris entre 0,025 % et 3%.

S'agissant du POS (III) monofonctionnel, le groupement alcényle directement lié à un atome de silicium est soit en bout de chaine, porté par un motif siloxyle de type M, soit pendant, c'est-à-dire porté par un motif siloxyle de type D. Les plus volontiers mis en oeuvre sont les polyorganosiloxanes monofonctionnels comme les (diméthylvinylsiloxy)-polydiméthylsiloxanes ou les polyorganosiloxanes de type poly(diméthylsiloxy)- (méthylvinylsiloxy)-α,ω (triméthylsiloxy).
Ces POS (III) sont des produits commerciaux comme par exemple les produits de la gamme Silopren_{®} TP 3354 ou Silopren_{®} TP 3608 de la société GE Bayer.
D'une manière préférée, le POS (III) possède une viscosité dynamique inférieure ou égale à 150 000 m.Pa.s et de préférence comprise entre 20 et 100 000 mPa.s.

S'agissant du POS (IV) non fonctionnalisé, les plus volontiers mis en oeuvre sont des huiles polydimethylsiloxanes-α,ω-(triméthylsiloxy) ou PDMS. Ces POS (IV) sont des produits commerciaux comme par exemple les produits de la gamme des RHODORSIL_{®} 47V (par exemple 47V20, 47V100, 47V500, 47V500, 47V12500 ou 47V30000) de la société RHODIA, et sont largement divulgués tant en ce qui concerne leurs structures que leurs synthèses dans la littérature technique.
D'une manière préférée, le POS (IV) est sensiblement linéaire et possède une viscosité dynamique inférieure ou égale à 50 000 mPa.s, de préférence comprise entre 20 et 40 000 mPa.s.

Le catalyseur (D) est un autre élément important de la composition selon l'invention. Il s'agit, de préférence, d'un complexe organométallique du platine ou bien encore de l'un des catalyseurs à base de platine traditionnellement mis en oeuvre pour la catalyse de réactions d'hydrosilylation entre des groupes SiH et des groupes SiVi. A titre d'exemples, on peut citer le platine noir, l'acide chloroplatinique, un acide chloroplatinique modifié par un alcool, un complexe de l'acide chloroplatinique avec une oléfine, un aldéhyde, un vinylsiloxane ou un alcool acétylénique, entre autres. Le brevet US N° 2 823 218 divulgue un catalyseur d'hydrosilylation du type acide chloroplatinique et le brevet US N°3 419 593 est relatif à des catalyseurs formés par des complexes d'acide chloroplatinique et d'organosilicone du type vinylsiloxane. Des complexes de platine et d'hydrocarbures utiles comme catalyseur d'hydrosilylation sont divulgués par les brevets US N° 3 159 601 et 3 159 662. Le brevet US N ° 3 723 497 décrit un acétylacétonate de platine et le brevet US N° 3 220 972 a pour objet des catalyseurs à base d'alcoolate de platine.
Pour le composant (D), on entend par quantité efficace d'au moins un catalyseur de réaction d'hydrosilylation , la quantité suffisante pour amorcer la réaction d'hydrosilylation. Concernant la quantité catalytiquement efficace à mettre en oeuvre, il va de soi que l'homme du métier du domaine considéré est parfaitement à même de déterminer la quantité optimale de catalyseur pour promouvoir la réaction d'hydrosilylation . Cette quantité dépend notamment de la nature du catalyseur et des POS en cause. Pour fixer les idées on peut indiquer qu'elle sera comprise entre 0,001 et 0,5 % en poids par rapport au poids total de la composition.

Pour améliorer la stabilité au stockage de la composition selon l'invention et pour fournir aux utilisateurs une forme commerciale aisément manipulable, il est prévu un système à au moins deux composants A et B comprenant les constituants (A), (B), (C) et éventuellement le constituant (E) de la composition silicone réticulable en gel adhésif par hydrosilylation telle que définie selon l'invention, avec comme condition que le catalyseur de réaction d'hydrosilylation (D) soit séparé du constituant (B).
Pour simplifier l'utilisation, il est préférable de proposer un système bi-composant dont les proportions A : B sont comprises entre 10 :100 et 100 :10 et de préférence entre 40 : 60 et 60 : 40, et encore plus préférentiellement de 50 : 50 parties en poids environ.

S'agissant de la préparation du gel, on peut préciser que la réticulation de la composition en gel intervient à la température ambiante ou après chauffage à des températures comprises entre 50 et 200° C par exemple. Dans ce contexte, les durées de réticulation nécessaires sont, par exemple, comprises entre quelques mn et 1 heure 30 mn. Le gel adhésif réticulé obtenu à partir de la composition décrite ci-dessus forme un objet à part entière de la présente invention.

S'agissant des applications, la composition et le gel selon l'invention peuvent être utilisés comme moyens amortisseurs de choc et de protection de composants électroniques ou analogues ("Potting"). La composition et/ou le gel peuvent ainsi être versés dans un conteneur comprenant des éléments électroniques sensibles montés sur un support quelconque, par exemple en résine époxy. Il s'agit en fait d'une immersion des éléments fragiles dans la composition silicone.

La composition et le gel peuvent également encapsuler des composés électroniques sensibles en vue de les protéger par d'autres moyens, par exemple par gainage de revêtement.
Compte tenu de ces propriétés adhésives particulièrement significatives, le gel silicone selon l'invention peut aussi être avantageusement utilisé pour la préparation d'adhésifs, de matériau médical, de préférence du type de ceux entrant dans la constitution des implants, prothèses, ciments ou analogues ; de matériau paramédical, de produits d'étanchéification, de mastics ou de produits d'assemblage.

La présente invention concerne également, à titre de produits nouveaux : les adhésifs, les matériaux médicaux et paramédicaux, tels que par exemple les pansements, et les moyens amortisseurs de choc et de protection, les ciments, mastics ou étanchéificateurs réalisés à partir de ce gel silicone.

Dans ces applications, il est possible d'exploiter tout ou partie des propriétés avantageuses du gel et de la composition selon l'invention : grande vitesse de réticulation, stabilité physique (viscoélasticité) à basse (jusqu'à - 120 °C) et à haute température, propriétés d'amortissement, qualité d'isolant notamment par rapport à l'air et à l'eau notamment, et enfin et surtout propriétés adhésives.
S'agissant des applications, la composition et le gel selon l'invention peuvent être utilisés comme moyens amortisseurs de choc et de protection de composants électroniques ou analogues ("Potting"). La composition et/ou le gel peuvent ainsi être versés dans un conteneur comprenant des éléments électroniques sensibles montés sur un support quelconque, par exemple en résine époxy. Il s'agit en fait d'une immersion des éléments fragiles dans la composition silicone.

La composition et le gel peuvent également encapsuler des composés électroniques sensibles en vue de les protéger par d'autres moyens e.g. : gainage de revêtement.... Compte tenu de ces propriétés adhésives particulièrement significatives, le gel silicone selon l'invention peut aussi être avantageusement utilisé pour la préparation :
- d'adhésifs,
- de matériau médical, de préférence du type de ceux entrant dans la constitution des implants, prothèses, ciments ou analogues;
- de produits d'étanchéification, de mastics, de composition de scellage, ou
- de produits d'assemblage.

L'invention concerne donc également l'utilisation du gel adhésif réticulé du système à au moins deux composants (A1) et (B1) selon l'invention ou de la composition silicone réticulable en gel adhésif par hydrosilylation selon l'invention, dans le domaine :
- des adhésifs,
- des enduits,
- des mastics d'étanchéification,
- de l'encapsulation et la protection d'unités électroniques,
- des matériaux pour la fabrication d'implants et de prothèses,
- des amortisseurs de choc et de protection,
- des ciments d'assemblage, et
- des pansements.

Les exemples non limitatifs qui suivent, montrent diverses possibilités de formulation des compositions selon l'invention ainsi que les caractéristiques et les propriétés des gels silicones obtenus par réticulation desdites compositions.

### EXEMPLES:

Les compositions décrites se présentent sous forme bicomposante et la réticulation s'effectue après mélange de deux parties nommées A et B dans un rapport 50 /50.
1) La liste ci-dessous décrit les matières premières utilisées dans les compositions des parties A et B de ce gel :
- POS (I) = huile poly(diméthylsiloxy)(siloxyméthylhydrogéno)-α,ω-(diméthylhydrogénosiloxy) ou l'huile poly(diméthylsiloxy)α,ω (diméthylhydrogénosiloxy) de viscosité 10 mPa.s contenant environ 5 à 10% en poids de groupements SIH.
- POS (II) = huile polydiméthylsiloxane α,ω (diméthylvinylsiloxy) de viscosité 300 mPa.s contenant environ 0,1% en poids de groupements vinyles.
- POS (III) monofonctionnel = huile (méthylvinylsiloxy)polydiméthylsiloxane-a ,ω-(triméthylsiloxy) de viscosité 300 mPa.s et contenant entre 0,5 et 0,13% en poids de groupement vinyle et contenant moins de 1 % molaire de motif siloxyle T.
- POS (IV) = huile polydiméthylsiloxane α,ω (triméthylsiloxy) de viscosité 300 mPa.s.
- Catalyseur (V) = complexe organométallique du platine utilisé comme catalyseur de réticulation ; les concentrations de ce catalyseur sont données en % en poids de Pt métal de degré d'oxydation = 0 par rapport à la masse totale de la composition

2) Le tableau 1 décrit les concentrations de chacun de ces constituants dans les parties A et B

**Tableau 1 : Constitution des compositions testées :**

| Composition | partie A | partie B |
|---|---|---|
| Constituants | Concentration en poids (%) | |
| POS (I) [SiH] | - | 3 |
| POS (II) [SiVi] | 63 | 63 |
| POS (III) [mono-SiVi] | 25 | 24 |
| POS (IV) [PDMS] | 12 | 10 |
| Catalyseur (D) | 0,01 | - |
| Viscosité mPa.s | 3500 | 3500 |
| Ratio SiH/SiVi | 1:1 | 1 :1 |

3) Méthodologie d'obtention des gels :
- Les gels sont préparés par simple mélange des constituants des compositions, dans un réacteur agité et placé à 25 °C.

4) Propriétés physiques et d'adhérence du gel obtenu

**Tableau 2 .**

| Réticulation | A + B | Comparatif Rhodorsil^{®} RT gel 8260 |
|---|---|---|
| module visqueux G", Pa | 1700 | 920 |
| module élastique G', Pa | 800 | 630 |
| Test de pénétration (mm) | 170 | 180 |
| Test d'adhésion | Très collant | collant |

Les propriétés viscoélastiques G' et G" ont été mesurées sur un rhéomètre Haake RS150 dans les conditions suivantes :
- Température = 120° C ;
- Balayage de fréquence = 1 hertz;

Le test de pénétration est effectué suivant un test analogue à la norme DIN ISO-2137 (poids du cône et de la tige : 62,5g).
Le test d'adhésion consiste en une comparaison qualitative entre le gel comparatif (Rhodorsil^{®} RT Gel 8260 vendu par la société Rhodia) et le gel selon l'invention.
Le gel obtenu présente une bonne stabilité dans le temps malgré un pourcentage en poids de polydiméthylsiloxane de l'ordre de 10% dans la composition (versus 50% pour les compositions standards).
Ces résultats montrent bien que le gel obtenu à partir de la composition présente de bonnes propriétés physiques et une bonne aptitude à l'adhérence.

## Revendications

1. - Composition silicone réticulable en gel adhésif par hydrosilylation, **caractérisée en ce qu'**elle est constituée essentiellement de:
(A) - au moins un polyorganosiloxane POS (I) comportant :
a) des motifs siloxyles terminaux de type M = (R)₂(H)SiO_{1/2}
dans lesquels les radicaux R, identiques ou différents, correspondent à un groupement alkyle linéaire ou ramifié en C1-C6, éventuellement substitué et/ou aryle substitué ou non, et
b) des motifs siloxyles, identiques ou différents, de type D = (R¹)ₚ(H)_{q}SiO_{2/2} dans lesquels les radicaux R¹ répondent à la même définition que R et p= 1 ou 2, q= 0 ou 1 et p + q= 2 ;
avec la condition selon laquelle le polyorganosiloxane POS (I) comprend au moins deux radicaux SiH par molécule ;
(B) - au moins un polyorganosiloxane POS (II) comportant :
a) des motifs siloxyles terminaux de type M = (X)ₛ(R²)ₜSiO_{1/2}
dans lesquels les radicaux R² répondent à la même définition que R, les radicaux X correspondent à des groupements alcényles ayant de 2 à 6 atomes de carbone, de préférence des groupements vinyles, s = 0 ou 1, t = 2 ou 3 et s+ t = 3 ; et
b) des motifs siloxyles, identiques ou différents, de type D = (X)ᵤR³)ᵥSiO_{2/2} dans lesquels les radicaux R³ répondent à la même définition que R, les radicaux X correspondent à des groupements alcényles ayant de 2 à 6 atomes de carbone, de préférence des groupements vinyles, u= 0 ou 1, v=1 ou 2 et u+ v = 2,
avec la condition selon laquelle le polyorganosiloxane POS (II) comprend au moins deux radicaux X par molécule ;
(C) - au moins un polyorganosiloxane monofonctionnel POS (III) essentiellement linéaire, ayant moins de 2 % molaire de motif siloxyle T= RSi0_{3/2} , de préférence moins de 1,5 % et encore plus préférentiellement moins de 1 % molaire de motif T= RSi0_{3/2} et comportant par molécule un groupement alcényle (X) ayant de 2 à 6 atomes de carbone directement lié à un atome de silicium, de préférence un groupement vinyle directement lié à un atome de silicium, ledit POS (III) comprenant :
a) des motifs siloxyles terminaux, identiques ou différents, de type
M = (X)_{w}(R⁴)ₓSiO_{1/2}
dans lequel les radicaux R⁴ répondent à la même définition que R, w= 0 ou 1, x= 2 ou 3 et w+ x = 3; et
b) au moins un motif siloxyle D = (X)_{y}(R⁵)_{z}SiO_{2/2}
dans lequel les radicaux R⁵ répondent à la même définition que R, y= 0 ou 1, z=1 ou 2 et y+ z= 2,
(D) - une quantité efficace d'au moins un catalyseur de réaction d'hydrosilylation ; et
(E) -éventuellement au moins un polyorganosiloxane non fonctionnalisé POS (IV) comportant :
a) des motifs siloxyles terminaux de type M = (R⁶)₃SiO_{1/2}
dans lesquels les radicaux R⁶ répondent à la même définition que R, et
b) des motifs siloxyles, identiques ou différents, de type D = (R⁷)₂SiO_{2/2} dans lesquels les radicaux R⁷ répondent à la même définition que R ;
avec la condition selon laquelle la quantité des constituants (A), (B), (C) et (E) est choisie de manière à ce que le rapport molaire r des atomes d'hydrogène liés au silicium aux radicaux alcényles (X) liés au silicium soit compris entre 0,2:1 et 5 :1.

2. - Composition silicone réticulable en gel adhésif par hydrosilylation selon la revendication 1 dans laquelle le rapport molaire r est compris entre 0,5 :1 à 1,5 :1.

3. - Composition silicone réticulable en gel adhésif par hydrosilylation selon l'une des revendications précédentes dans laquelle le rapport molaire r est de 1 :1.

4. - Composition silicone réticulable en gel adhésif par hydrosilylation selon l'une des revendications précédentes dans laquelle les radicaux R¹, R², R³, R⁴, R⁵, R⁶, R⁷ et R⁸ sont des groupements méthyles.

5. - Composition silicone réticulable en gel adhésif par hydrosilylation selon l'une des revendications précédentes dans laquelle le catalyseur de réaction d'hydrosilylation est à base de platine.

6. - Composition silicone réticulable en gel adhésif par hydrosilylation selon l'une des revendications précédentes dans laquelle :
- le POS (I) est sensiblement linéaire et possède une viscosité dynamique inférieure ou égale à 10000 m.Pa.s, de préférence à 6000 mPa.s et encore plus préférentiellement comprise entre 5 et 5000 mPa.s;
- le POS (II) est sensiblement linéaire et possède une viscosité dynamique inférieure ou égale à 200 000 m.Pa.s, de préférence à 170 000 mPa.s et encore plus préférentiellement comprise entre 20 et 165 000 mPa.s.;
- le POS (III) possède une viscosité dynamique inférieure ou égale à 150000 m.Pa.s et de préférence comprise entre 20 et 100000 mPa.s ; et/ou
- le POS (IV) est sensiblement linéaire et possède une viscosité dynamique inférieure ou égale à 50 000 mPa.s, de préférence comprise entre 20 et 40 000 mPa.s ;

7. - Système à au moins deux composants (A1) et (B1) comprenant les constituants (A), (B), (C), (D) et éventuellement le constituant (E) de la composition silicone réticulable en gel adhésif par hydrosilylation selon l'une des revendications 1 à 6, avec comme condition que le catalyseur de réaction d'hydrosilylation (D) soit séparé du constituant (B).

8. **-** Gel adhésif réticulé obtenu par réticulation de la composition silicone réticulable en gel adhésif par hydrosilylation selon l'une des revendications 1 à 6 ou par réticulation du système à au moins deux composants (A1) et (B1) selon la revendication 7.

9. - Utilisation du gel adhésif réticulé selon la revendication 8, du système à au moins deux composants (A1) et (B1) selon la revendication 7 ou de la composition silicone réticulable en gel adhésif par hydrosilylation selon l'une des revendications 1 à 6 dans le domaine :
- des adhésifs,
- des enduits,
- des mastics d'étanchéification,
- de l'encapsulation et la protection d'unités électroniques,
- des matériaux pour la fabrication d'implants et de prothèses,
- des amortisseurs de choc et de protection,
- des ciments d'assemblage, et
- des pansements.

## Claims

1. A silicone composition which can be crosslinked into an adhesive gel by hydrosilylation, **characterized in that** it is mainly composed of:
(A)- at least one polyorganosiloxane POS(I) comprising:
a) end siloxyl units of type M = (R)₂(H)SiO_{1/2}
in which the R radicals, which are identical or different, correspond to an optionally substituted linear or branched C₁-C₆ alkyl group and/or a substituted or unsubstituted aryl group; and
b) identical or different siloxyl units of type D = (R¹)ₚ(H)_{q}SiO_{2/2}
in which the R¹ radicals correspond to the same definition as R and p = 1 or 2, q = 0 or 1 and p + q = 2;
with the condition according to which the polyorganosiloxane POS(I) comprises at least two SiH radicals per molecule;
(B)- at least one polyorganosiloxane POS (II) comprising:
a) end siloxyl units of type M = (X)ₛ(R²)ₜSiO_{1/2}
in which the R² radicals correspond to the same definition as R, the X radicals correspond to alkenyl groups having from 2 to 6 carbon atoms, preferably vinyl groups, s = 0 or 1, t = 2 or 3 and s + t = 3; and
b) identical or different siloxyl units of type D = (X)ᵤ(R³)ᵥSiO_{2/2}
in which the R³ radicals correspond to the same definition as R, the X radicals correspond to alkenyl groups having from 2 to 6 carbon atoms, preferably vinyl groups, u = 0 or 1, v = 1 or 2 and u + v = 2;
with the condition according to which the polyorganosiloxane POS (II) comprises at least two X radicals per molecule;
(C)- at least one monofunctional polyorganosiloxane POS (III) which is essentially linear, having less than 2 mol% of siloxyl unit T = RSiO_{3/2}, preferably less than 1.5 mol% and even more preferentially less than 1 mol% of unit T = RSi0_{3/2} and comprising, per molecule, an alkenyl group (X) having from 2 to 6 carbon atoms directly linked to a silicon atom, preferably a vinyl group directly linked to a silicon atom, said POS(III) comprising:
a) identical or different end siloxyl units of type M = (X)_{w}(R⁴)ₓSiO_{1/2}
in which the R⁴ radicals correspond to the same definition as R, w = 0 or 1, x = 2 or 3 and w + x = 3; and
b) at least one siloxyl unit D = (X)_{y}(R⁵)_{z}SiO_{2/2}
in which the R⁵ radicals correspond to the same definition as R, y = 0 or 1, z = 1 or 2 and y + z = 2;
(D)- an effective amount of at least one hydrosilylation reaction catalyst; and
(E)- optionally at least one unfunctionalized polyorganosiloxane POS(IV) comprising:
a) end siloxyl units of type M = (R⁶)₃SiO_{1/2}
in which the R⁶ radicals correspond to the same definition as R; and
b) identical or different siloxyl units of type D = (R⁷)₂SiO_{2/2}
in which the R⁷ radicals correspond to the same definition as R;
with the condition according to which the amount of constituents (A), (B), (C) and (E) is chosen so that the molar ratio r of the hydrogen atoms bonded to silicon to the alkenyl radicals (X) bonded to silicon is between 0.2/1 and 5/1.

2. The silicone composition which can be crosslinked into an adhesive gel by hydrosilylation as claimed in claim 1, **characterized in that** the molar ratio r is between 0.5/1 to 1.5/1.

3. The silicone composition which can be crosslinked into an adhesive gel by hydrosilylation as claimed in one of the preceding claims, **characterized in that** the molar ratio r is 1/1.

4. The silicone composition which can be crosslinked into an adhesive gel by hydrosilylation as claimed in one of the preceding claims, **characterized in that** the R¹, R², R³, R⁴, R⁵, R⁶, R⁷ and R⁸ radicals are methyl groups.

5. The silicone composition which can be crosslinked into an adhesive gel by hydrosilylation as claimed in one of the preceding claims, **characterized in that** the hydrosilylation reaction catalyst is based on platinum.

6. The silicone composition which can be crosslinked into an adhesive gel by hydrosilylation as claimed in one of the preceding claims, **characterized in that**:
- POS(I) is substantially linear and has a dynamic viscosity less than or equal to 10 000 mPa.s, preferably less than or equal to 6000 mPa.s and even more preferentially between 5 and 5000 mPa.s;
- POS(II) is substantially linear and has a dynamic viscosity less than or equal to 200 000 mPa.s, preferably less than or equal to 170 000 mPa.s and even more preferentially between 20 and 165 000 mPa.s;
- POS(III) has a dynamic viscosity less than or equal to 150 000 mPa.s and preferably between 20 and 100 000 mPa.s; and/or
- POS(IV) is substantially linear and has a dynamic viscosity less than or equal to 50 000 mPa.s, preferably between 20 and 40 000 mPa.s.

7. A system having at least two components (A1) and (B1) comprising the constituents (A), (B), (C), (D) and optionally the constituent (E) of the silicone composition which can be crosslinked into an adhesive gel by hydrosilylation as claimed in one of claims 1 to 6, with the condition that the hydrosilylation reaction catalyst (D) is separate from the constituent (B).

8. A crosslinked adhesive gel obtained by crosslinking the silicone composition which can be crosslinked into an adhesive gel by hydrosilylation as claimed in one of claims 1 to 6, or by cross linking the system having at least two components (A1) and (B1) as claimed in claim 7.

9. The use of the crosslinked adhesive gel as claimed in claim 8, of the system having at least two components (A1) and (B1) as claimed in claim 7 or of the silicone composition which can be crosslinked into an adhesive gel by hydrosilylation as claimed in one of claims 1 to 6, in the field of:
- adhesives;
- coatings;
- sealants;
- encapsulating and protecting electronic units;
- materials for manufacturing implants and prostheses;
- shock and protective absorbers;
- joint cements; and
- dressings.

## Patentansprüche

1. Durch Hydrosilylierung zu einem adhäsiven Gel vernetzbare Silikonzusammensetzung, **dadurch gekennzeichnet, dass** sie im Wesentlichen besteht aus:
(A) mindestens einem Polyorganosiloxan POS (I), das folgendes einschließt:
a) terminale Siloxyleinheiten vom Typ M = (R)₂(H)SiO_{1/2}, wobei die Reste R, die gleich oder verschieden sind, einer linearen oder verzweigten C₁₋₆ -Alkylgruppe, gegebenenfalls substituiert und/oder Aryl-substituiert oder nicht, entsprechen, und
b) Siloxyleinheiten, die gleich oder verschieden sind, vom Typ D = (R¹)ₚ(H)_{q}SiO_{2/2}, wobei die Reste R¹ der gleichen Definition wie R gehorchen und p = 1 oder 2, q = 0 oder 1 und p + q = 2 gilt;
mit der Maßgabe, dass das Polyorganosiloxan POS (I) mindestens zwei SiH-Reste pro Molekül enthält;
(B) mindestens einem Polyorganosiloxan POS (II), das folgendes einschließt:
a) terminale Siloxyleinheiten vom Typ M = (X)ₛ(R²)ₜSiO_{1/2}, wobei die Reste R² der gleichen Definition wie R gehorchen, die Reste X Alkenylgruppen mit 2 bis 6 Kohlenstoffatomen, vorzugsweise Vinylgruppen entsprechen, s = 0 oder 1, t = 2 oder 3 und s + t = 3 gilt und
b) Siloxyleinheiten, die gleich oder verschieden sind, vom Typ D = (X)ᵤ(R³)ᵥSiO_{2/2}, wobei die Reste R³ der gleichen Definition wie R gehorchen, die Reste X Alkenylgruppen mit 2 bis 6 Kohlenstoffatomen, vorzugsweise Vinylgruppen entsprechen, u = 0 oder 1, v = 1 oder 2 und u + v = 2 gilt,
mit der Maßgabe, dass das Polyorganosiloxan POS (II) mindestens zwei Reste X pro Molekül einschließt;
(C) mindestens einem monofunktionellen Polyorganosiloxan POS (III), das im Wesentlichen linear ist, mit mindestens 2 Mol-% der Siloxyleinheit T = RSiO_{3/2}, vorzugsweise mit mindestens 1,5 Mol-% und noch stärker bevorzugt mit mindestens 1 Mol-% der Einheit T = RSiO_{3/2} und das pro Molekül eine Alkenylgruppe (X) mit 2 bis 6 Kohlenstoffatomen, die direkt an ein Siliciumatom gebunden ist, vorzugsweise eine Vinylgruppe, die direkt an ein Siliciumatom gebunden ist, enthält, wobei das POS (III) folgendes einschließt:
a) terminale Siloxyleinheiten, die gleich oder verschieden sind, vom Typ M = (X)_{w}(R⁴)ₓSiO_{1/2}, wobei die Reste R⁴ der gleichen Definition wie R gehorchen, w = 0 oder 1, x = 2 oder 3 und w + x = 3 gilt; und
b) mindestens eine Siloxyleinheit D = (X)_{y}(R⁵)_{z}SiO_{2/2}, wobei die Reste R⁵ der gleichen Definition wie R gehorchen, y = 0 oder 1, z = 1 oder 2 und y+z=2 gilt,
(D) einer wirksamen Menge von mindestens einem Hydrosiylierungsreaktionskatalysator; und
(E) gegebenenfalls mindestens einem nicht funktionalisierten Polyorganosiloxan POS (IV), das folgendes einschließt:
a) terminale Siloxyleinheiten vom Typ M = (R⁶)₃SiO_{1/2}, wobei die Reste R⁶ der gleichen Definition wie R gehorchen, und
b) Siloxyleinheiten, die gleich oder verschieden sind, vom Typ D = (R⁷)₂Si0_{2/2}, wobei die Reste R⁷ der gleichen Definition wie R gehorchen;
mit der Maßgabe, dass die Menge der Bestandteile (A), (B), (C) und (E) so gewählt ist, dass das Molverhältnis r der an Silicium gebundenen Wasserstoffatome zu den an Silicium gebundenen Alkenylresten X 0,2:1 bis 5:1 beträgt.

2. Durch Hydrosilylierung zu einem adhäsiven Gel vernetzbare Silikonzusammensetzung nach Anspruch 1, wobei das Molverhältnis r 0,5:1 bis 1,5:1 beträgt.

3. Durch Hydrosilylierung zu einem adhäsiven Gel vernetzbare Silikonzusammensetzung nach einem der vorhergehenden Ansprüche, wobei das Molverhältnis r 1:1 beträgt.

4. Durch Hydrosilylierung zu einem adhäsiven Gel vernetzbare Silikonzusammensetzung nach einem der vorhergehenden Ansprüche, wobei die Reste R¹, R², R³, R⁴, R⁵, R⁶, R⁷ und R⁸ Methylgruppen sind.

5. Durch Hydrosilylierung zu einem adhäsiven Gel vernetzbare Silikonzusammensetzung nach einem der vorhergehenden Ansprüche, wobei der Hydrosilylierungsreaktionskatalysator auf Platinbasis ist.

6. Durch Hydrosilylierung zu einem adhäsiven Gel vernetzbare Silikonzusammensetzung nach einem der vorhergehenden Ansprüche, wobei:
- das POS (I) im Wesentlichen linear ist und eine dynamische Viskosität von kleiner oder gleich 10.000 mPa.s, vorzugsweise von 6.000 mPa.s, und noch stärker bevorzugt von 5 bis 5.000 mPa.s besitzt;
- das POS (II) im Wesentlichen linear ist und eine dynamische Viskosität von kleiner oder gleich 200.000 mPa.s, vorzugsweise bis 170.000 mPa.s und noch stärker bevorzugt von 20 bis 165.000 mPa.s besitzt;
- das POS (III) eine dynamische Viskosität von kleiner oder gleich 150.000 mPa.s und vorzugsweise von 20 bis 100.000 mPa.s besitzt; und/oder
- das POS (IV) im Wesentlichen linear ist und eine dynamische Viskosität von kleiner oder gleich 50.000 mPa.s, vorzugsweise von 20 bis 40.000 mPa.s besitzt.

7. System mit mindestens zwei Bestandteilen (A1) und (B1), die die Bestandteile (A), (B), (C), (D) und gegebenenfalls den Bestandteil (E) der durch Hydrosilylierung zu einem adhäsiven Gel vernetzbaren Silikonzusammensetzung nach einem der Ansprüche 1 bis 6 enthalten, mit der Maßgabe, dass der Hydrosilylierungsreaktionskatalysator (D) von Bestandteil (B) getrennt ist.

8. Vernetztes adhäsives Gel, das durch Vernetzung der durch Hydrosilylierung zu einem adhäsiven Gel vernetzbaren Silikonzusammensetzung nach einem der Ansprüche 1 bis 6 oder durch Vernetzung des Systems von mindestens zwei Bestandteilen (A1) und (B 1) nach Anspruch 7 erhalten wird.

9. Verwendung des vernetzten adhäsiven Gels nach Anspruch 8, des Systems mit mindestens zwei Bestandteilen (A1) und (B1) nach Anspruch 7 oder der durch Hydrosilylierung zu einem adhäsiven Gel vernetzbaren Silikonzusammensetzung nach einem der Ansprüche 1 bis 6 auf dem Gebiet:
- Klebstoffe,
- Anstriche,
- Dichtungskitte,
- Verkapselung und Schutz von elektronischen Teilen,
- Materialien zur Herstellung von Implantaten und Prothesen,
- Stoßfänger und Schutzpuffer,
- Verbundzemente, und
- Pflaster.
